(19) **Europäisches Patentamt**
**European Patent Office**
**Office européen des brevets**

(11) **EP 1 318 599 B1**

(12) **FASCICULE DE BREVET EUROPEEN**

(45) Date de publication et mention
de la délivrance du brevet:
**15.10.2008 Bulletin 2008/42**

(51) Int Cl.:
***H03F 1/30*** *(2006.01)*

(21) Numéro de dépôt: **01204672.8**

(22) Date de dépôt: **04.12.2001**

(54) **Sytème électronique complémentaire d'abaissement de la consommation électrique**

Komplementär aufgebautes elektronisches System für einen geringen elektrischen Verbrauch

Complementary electronic system for lowering electric consumption

(84) Etats contractants désignés:
**AT BE CH CY DE DK ES FI FR GB GR IE IT LI LU MC NL PT SE TR**

(43) Date de publication de la demande:
**11.06.2003 Bulletin 2003/24**

(73) Titulaire: **EM Microelectronic-Marin SA**
**2074 Marin (CH)**

(72) Inventeur: **Godat, Yves**
**2087 Cornaux (CH)**

(74) Mandataire: **Ravenel, Thierry Gérard Louis et al**
**I C B,**
**Ingénieurs Conseils en Brevets SA,**
**7, rue des Sors**
**2074 Marin (CH)**

(56) Documents cités:
**EP-A- 0 443 507       US-A- 3 887 881**
**US-A- 3 937 001       US-A- 3 956 714**
**US-A- 4 023 112       US-A- 5 991 177**

**Description**

La présente invention concerne un système électronique comportant au moins un premier dispositif électronique à composants semi-conducteurs alimenté par une tension d'alimentation $V_{DD}$-$V_{SS}$ entre des première et seconde bornes d'alimentation, le premier dispositif recevant un signal d'entrée par au moins une borne d'entrée, et fournissant un signal de sortie par une borne de sortie. Le système permet d'abaisser la consommation électrique de certains circuits électroniques conventionnels lorsqu'il leur est associé.

En effet, les circuits électroniques à composants semi-conducteurs ont notamment pour particularité de présenter différents régimes de fonctionnement en fonction de la tension d'alimentation qui leur est appliquée. L'utilisateur de tels circuits souhaite généralement pouvoir disposer d'une plage d'utilisation, en tension d'alimentation, suffisamment étendue pour prévenir notamment les risques de variations brutales de cette tension d'alimentation. Par conséquent, les domaines d'utilisation courante des circuits électroniques à composants semi-conducteurs sont souvent précisément délimités dans la région des basses tensions d'alimentation, en ce qui concerne les plages correspondant à un régime de fonctionnement stable.

Le domaine de l'électronique est constamment à la recherche de solutions permettant d'abaisser la consommation des circuits, passant notamment par un abaissement de la tension d'alimentation minimale admissible pour que lesdits circuits fonctionnent de façon stable. Une solution couramment utilisée et régulièrement améliorée consiste à modifier les caractéristiques physiques des composants à semi-conducteurs, tel que leur géométrie, la nature des dopants utilisés ou leur quantité, de telle manière que la valeur de leur tension de seuil soit abaissée.

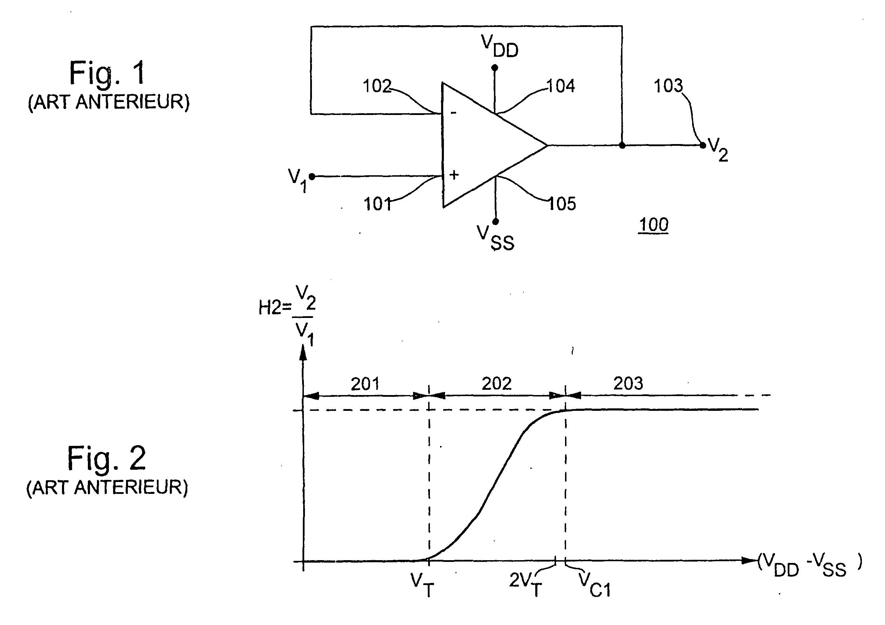

On a représenté, à titre d'exemple non limitatif, sur la figure 1 un circuit électronique courant, plus précisément un circuit d'amplification 100 de type courant (de gain égal à 1 ici) et comportant notamment des éléments semi-conducteurs (non représentés). Le circuit d'amplification 100 comporte en particulier deux bornes d'entrées 101 et 102, une borne de sortie 103 et deux bornes d'alimentation, dont une haute 104 et une basse 105. La borne d'entrée 101 est alimentée par un signal d'entrée $V_1$ tandis que la borne d'entrée 102 est reliée à la borne de sortie 103 constituant ainsi une boucle de contre-réaction. En outre, la borne de sortie 103 est portée à un potentiel de sortie $V_2$. La borne d'alimentation haute 104 est reliée à un potentiel haut $V_{DD}$ tandis que la borne d'alimentation basse 105 est reliée à un potentiel bas $V_{SS}$.

On observe sur la figure 2 le comportement que présente le circuit ou étage d'amplification représenté sur la figure 1 lorsqu'on fait varier la différence de potentiels $V_{DD}$-$V_{SS}$ en appliquant à l'entrée 101 un potentiel $V_1$ d'amplitude constante. L'échelle des ordonnées sur la courbe de la figure 2 correspond au rapport $V_2/V_1$ de la tension de sortie sur la tension d'entrée, autrement dit au gain ou à la fonction de transfert H2 de l'étage d'amplification représenté sur la figure 1. On constate alors que le gain H2, dont la valeur est négligeable pour de faibles valeurs de la différence de potentiels $V_{DD}$-$V_{SS}$, 201, augmente rapidement à partir du moment où la différence de potentiels $V_{DD}$-$V_{SS}$ atteint une valeur notée $V_T$ qui est la tension de seuil des composants semi-conducteurs entrant dans la construction de l'étage d'amplification. La courbe définit alors une portion 202 constituant une zone de transition dans le comportement de l'étage d'amplification 100. On constate en outre une dernière portion 203 sur la courbe du gain H2 représentée sur la figure 2 située après la valeur $V_{C1}$, dans la zone où la valeur de la différence de potentiels $V_{DD}$-$V_{SS}$ est notablement supérieure à $V_T$. Dans cette dernière portion 203, la valeur du gain d'amplification H2 reste sensiblement constante. Généralement $V_{C1}$ correspond à une valeur supérieure à 2 $V_T$ voire 2,5 $V_T$.

On peut donc aisément déduire de l'analyse de la figure 2 qu'un étage d'amplification tel que celui représenté sur la figure 1 peut être utilisé comme amplificateur à gain H2 constant, pour différentes valeurs de tension d'alimentation, à la condition que ces dernières soient suffisamment supérieures à la tension de seuil des composants semi-conducteurs employés pour que l'on se situe au niveau de la portion 203.

Toutefois, la solution consistant à modifier les caractéristiques physiques des composants semi-conducteurs présente souvent l'inconvénient de rendre le procédé de fabrication correspondant beaucoup plus complexe et donc plus coûteux que les procédés conventionnels.

La présente invention a pour but principal d'améliorer la consommation des circuits électroniques à composants semi-conducteurs de l'art antérieur tout en palliant les inconvénients de l'art antérieur susmentionnés.

A cet effet, l'invention a pour objet un système électronique du type mentionné plus haut, caractérisé en ce que le dispositif électronique est configuré pour présenter un gain en tension H1 entre le signal de sortie et le signal d'entrée dont la représentation graphique en fonction de ladite tension d'alimentation comporte trois domaines successifs, le premier domaine s'étendant pour des valeurs de $V_{DD}$-$V_{SS}$ inférieure ou égale à une valeur $V_T$ de tension de seuil des composants semi-conducteurs, ledit domaine correspondant à une première valeur h1 constante du gain H1, le second domaine s'étendant depuis $V_T$ jusqu'à une valeur $V_{C2}$, correspondant à une diminution progressive du gain H1 et le troisième domaine s'étendant au-dessus de $V_{C2}$, correspondant à une seconde valeur h2 constante du gain H1 inférieure à la première valeur h1 constante du gain H1.

Plus précisément, un but principal de la présente invention est de fournir un système électronique du type décrit plus haut et dont la borne de sortie au moins est susceptible d'être connectée à un second dispositif électronique à composants semi-conducteurs également alimenté par la tension $V_{DD}$-$V_{SS}$ et présentant une fonction de transfert H2 dont la représentation graphique en fonction de la tension d'alimentation comporte trois domaines successifs, le premier domaine s'étendant depuis les faibles valeurs de $V_{DD}$-$V_{SS}$ jusqu'à une valeur $V_T$, appelée tension de seuil des composants semi-conducteurs, ledit domaine correspondant à une valeur de H2 faible et sensiblement constante, le second domaine s'étendant depuis $V_T$ jusqu'à une valeur $V_{C1}$, correspondant à une croissance à forte pente de H2 et le troisième domaine s'étendant au-delà de $V_{C1}$, correspondant à une valeur de H2 élevée et sensiblement constante, caractérisé par le fait que ledit premier dispositif électronique présente une fonction de transfert H1 variant en fonction de la tension d'alimentation $V_{DD}$-$V_{SS}$, de telle manière que le système électronique présente une fonction de transfert H3 variant en fonction de la tension d'alimentation $V_{DD}$-$V_{SS}$ de façon à être sensiblement constante à partir d'une valeur de tension d'alimentation $V_{C3}$ inférieure à $V_{C1}$.

Pour parvenir à ce résultat, le premier dispositif électronique est préférablement réalisé de telle manière qu'il comporte au moins un étage de division de tension de type capacitif connecté d'une part à une première desdites deux bornes d'alimentation et d'autre part à ladite borne d'entrée, ledit étage de division de tension comportant au moins un transistor réalisé en technologie SOI comprenant une grille reliée notamment à ladite borne de sortie dudit premier dispositif électronique, une source et un drain connectés l'un à l'autre et reliés à ladite première borne d'alimentation, ledit premier dispositif comprenant également des moyens de polarisation dudit transistor reliés d'une part à la seconde desdites deux bornes d'alimentation et d'autre part à la grille dudit transistor.

Un tel système est particulièrement bien adapté lorsque le second dispositif décrit plus haut comprend au moins un circuit électronique pris dans le groupe comprenant les amplificateurs et les oscillateurs à composants semi-conducteurs, dans la mesure où ces circuits électroniques présentent généralement des courbes de fonction de transfert du type de celle représentée sur la figure 2.

Bien entendu, l'homme de l'art saura mettre en oeuvre le système selon l'invention, sans difficulté particulière, pour abaisser la consommation de tout autre circuit à semi-conducteur que ceux susmentionnés et présentant une caractéristique du type décrit plus haut.

Dans un mode de réalisation préféré, le premier dispositif comporte en outre une seconde borne de sortie, un second étage de division de tension de type capacitif connecté d'une part à la seconde desdites deux bornes d'alimentation et d'autre part à ladite borne d'entrée, le second étage de division de tension comportant au moins un second transistor de type SOI dont le type de dopage est différent de celui du transistor dudit premier étage et comprenant une grille reliée notamment à ladite seconde borne de sortie, une source et un drain connectés l'un à l'autre et reliés à ladite seconde borne d'alimentation, ledit second dispositif comprenant également des moyens de polarisation du second transistor reliés d'une part à la première desdites deux bornes d'alimentation et d'autre part à la grille dudit second transistor.

Dans ce cas, la borne d'entrée du second dispositif électronique peut être connectée soit à la première soit à la seconde des deux sorties du premier dispositif électronique. On peut en outre prévoir que le système électronique selon l'invention comporte un troisième dispositif électronique comprenant un circuit électronique pris dans le même groupe que le circuit électronique du second dispositif et connecté à l'autre des sorties du premier dispositif électronique.

Dans une variante préférée du mode de réalisation précédent, on peut ajouter un étage de sortie entre les bornes de sortie des second et troisième dispositifs et la borne de sortie du système complet, ledit étage de sortie assurant la recombinaison des signaux respectivement délivrés par lesdites deux bornes de sortie.

On considère, à titre d'exemple illustratif, un cas particulier des différents modes de réalisation qui viennent d'être décrits dans lequel le circuit électronique employé dans le second dispositif est un amplificateur conventionnel tel que représenté sur la figure 1. Grâce à ses caractéristiques, le système électronique selon l'invention permet alors d'amplifier un signal avec un gain constant tout en abaissant la différence nécessaire entre les potentiels d'alimentation haut et bas, c'est-à-dire la tension d'alimentation du circuit, donc en diminuant la consommation d'énergie dudit circuit. En effet, pour fonctionner en amplification, les transistors présents dans les étages d'amplification doivent être polarisés avec une tension au moins égale à une valeur particulière, appelée tension de seuil. Cette tension de seuil varie généralement d'un transistor à l'autre en fonction de leurs paramètres géométriques et physiques respectifs. La courbe de transfert des transistors montés en amplification, en fonction de leur tension de polarisation, présente une zone de transition autour de la tension de seuil. Par conséquent, un étage d'amplification à transistors présente un gain variant lorsque la tension d'alimentation du circuit varie autour de la tension de seuil. Lorsque la valeur de la tension d'alimentation du circuit dépasse suffisamment la valeur de la tension de seuil, le gain procuré par l'étage d'amplification devient constant. Typiquement, les amplificateurs à gain constant de l'art antérieur sont donc alimentés avec des tensions d'alimentation notablement éloignées de la tension de seuil correspondante afin d'éviter les problèmes susmentionnés.

Le système électronique selon la présente invention comporte, dans un premier dispositif électronique, un circuit de division de tension comprenant des éléments capacitifs à capacité variable permettant de tenir compte et même de compenser la variation du gain d'amplification du circuit électronique utilisé dans le second dispositif en fonction de la tension d'alimentation, dans la zone de transition des transistors utilisés. Plus précisément, lorsque la tension d'alimentation du système augmente à partir de la valeur de la tension de seuil, le gain d'un circuit d'amplification augmente de façon notable. Dans le même temps, il est prévu que la valeur de la capacité variable augmente également, dans les mêmes proportions, de telle manière que le signal sortant de l'étage de division de tension et entrant dans le circuit d'amplification présente une amplitude plus faible. Ainsi, on peut obtenir un gain global pour le système qui ne varie pas avec sa tension d'alimentation, par un simple effet de compensation entre les circuits de division de tension et d'amplification.

Le système selon la présente invention devient particulièrement avantageux lorsque les éléments capacitifs sont réalisés sous la forme de transistors, en particulier en technologie du type Silicium sur Isolant (SOI). En effet, la capacité d'un transistor SOI varie de façon importante en fonction de la tension de polarisation qui lui est appliquée. Lorsque ladite tension de polarisation est inférieure ou égale à la tension de seuil $V_T$ du transistor, sa capacité est faible tandis qu'elle augmente rapidement, lorsque ladite tension de polarisation augmente à partir de $V_T$, pour atteindre une valeur plus élevée et constante au-delà d'une certaine valeur de la tension de polarisation. Ainsi, il est possible d'ajuster les caractéristiques physiques de ces éléments capacitifs à capacité variable de telle manière que leur comportement, en fonction de la tension d'alimentation appliquée au système, compense le comportement transitoire des éléments entrant en jeu dans le circuit d'amplification. Il est ainsi possible, conformément à la présente invention, d'alimenter le système avec une tension plus faible que dans le cas des circuits d'amplification de l'art antérieur, tout en conservant une valeur constante pour le gain en amplification.

L'invention sera mieux comprise à l'aide de la description suivante d'un exemple d'exécution en référence au dessin annexé dans lequel:

- la figure 1 représente un étage d'amplification simple, alimenté par une tension d'alimentation $V_{DD}$-$V_{SS}$ tel que connu de l'art antérieur;
- la figure 2 représente la courbe décrivant le comportement du facteur d'amplification de l'étage d'amplification H2 représenté sur la figure 1, en fonction de la tension d'alimentation qui lui est appliquée;
- la figure 3 représente une vue en coupe d'un exemple de réalisation d'un transistor SOI selon la présente invention;
- la figure 4a représente un schéma électrique d'un pont diviseur de tension classique de type capacitif comportant deux condensateurs;
- la figure 4b représente un schéma électrique d'un étage de division de tension selon la présente invention comportant notamment le transistor représenté sur la figure 3;

- la figure 5 représente le rapport des tensions de sortie sur entrée de l'étage de division de tension représenté sur la figure 4, en fonction de la tension d'alimentation appliquée au circuit;
- la figure 6 représente un diagramme schématique permettant de définir la structure générale du système électronique selon la présente invention;
- la figure 7 représente le schéma électrique d'un exemple de réalisation simple du système électronique selon la présente invention, et
- la figure 8 représente le comportement de la fonction de transfert du système électronique représenté sur la figure 7 en fonction de la tension d'alimentation appliquée audit système et comparé au comportement d'un circuit électronique de l'art antérieur.

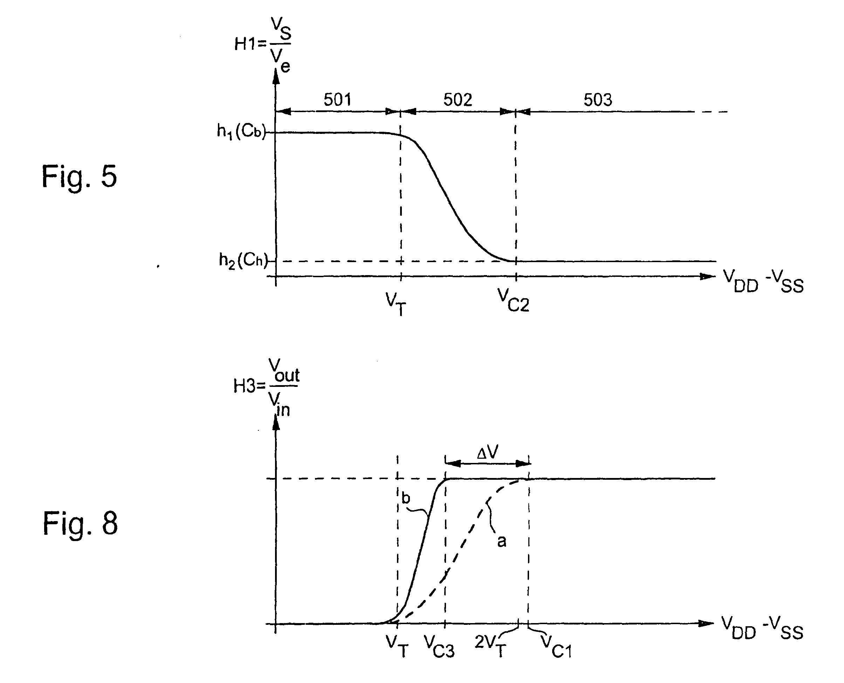

Comme décrit plus haut, la présente invention apporte une solution combinant un circuit électronique conventionnel, comme par exemple le circuit d'amplification 100 représenté sur la figure 1, avec un dispositif électronique additionnel de telle manière que la portion 203 de la figure 2 débute à partir d'une valeur $V_{C3}$ (représentée sur la figure 8) inférieure à $V_{C1}$, voire inférieure à $2V_T$. Ainsi, pour un circuit d'amplification et un gain d'amplification H2 donnés, l'utilisateur du système complet selon la présente invention peut utiliser une différence de potentiels d'alimentation plus faible que dans le cas des circuits d'amplification de l'art antérieur. Cette caractéristique permet avantageusement de consommer moins d'énergie pour un gain d'amplification donné qu'avec un circuit de l'art antérieur.

Le principe de base sur lequel repose la présente invention consiste à limiter l'amplitude du signal entrant dans le circuit d'amplification en fonction de la tension d'alimentation et de l'augmentation correspondante du gain d'amplification H2. Ainsi, pour deux valeurs de tension d'alimentation différentes, prises dans la portion 202 de la figure 2, le gain de l'étage d'amplification H2 est fixé à deux valeurs différentes et l'amplitude du signal à amplifier est par conséquent atténuée différemment dans ces deux cas conformément à l'invention, de telle manière que le gain global H3 du système d'amplification complet est le même pour lesdites deux valeurs de tension d'alimentation.

En pratique, pour effectuer cette limitation d'amplitude du signal entrant dans le circuit d'amplification, on peut par exemple utiliser un pont diviseur de tension de type capacitif comme dispositif électronique additionnel. Dans ce cas, on peut prévoir que l'un des éléments capacitifs composant ledit pont diviseur présente une capacité variable, et en particulier que celle-ci dépend directement de la valeur choisie pour la tension d'alimentation du circuit.

Dans un mode de réalisation préféré de l'invention, il est prévu d'utiliser un transistor, occupant moins d'espace sur un circuit intégré qu'un condensateur conventionnel, pour assurer la fonction dudit élément à capacité variable. En effet, un transistor dont la source et le drain sont court-circuités se comporte comme un condensateur dont la capacité fluctue en fonction de la tension de polarisation qui lui est appliquée. Généralement, cette dernière caractéristique est perçue comme un inconvénient dans le domaine des fabricants de puces électroniques, dans la mesure où elle délimite une plage d'utilisation du transistor en tant que condensateur, en termes de tension d'alimentation.

La courbe correspondant au comportement de la capacité d'un transistor, en fonction de la tension de polarisation qui lui est appliquée, présente la même allure générale que la courbe représentée sur la figure 2. Dans ce cas, la portion 201 de ladite courbe correspondrait à une valeur basse $C_b$ de la capacité, la portion 202 correspondrait à la zone de transition et la portion 203 correspondrait à une valeur haute $C_h$ de la capacité.

De manière générale, le rapport $C_h/C_b$ atteint rarement 2 pour un transistor réalisé en technologie CMOS (Complementary Metal Oxide Semiconductor) tandis qu'il peut atteindre des valeurs aussi élevées qu'environ 15 pour un transistor réalisé en technologie SOI (Silicon On Insulator). Ces deux types de transistors peuvent être employés pour réaliser la présente invention, mais il est évident qu'un transistor réalisé en technologie SOI offre une plus grande souplesse d'utilisation.

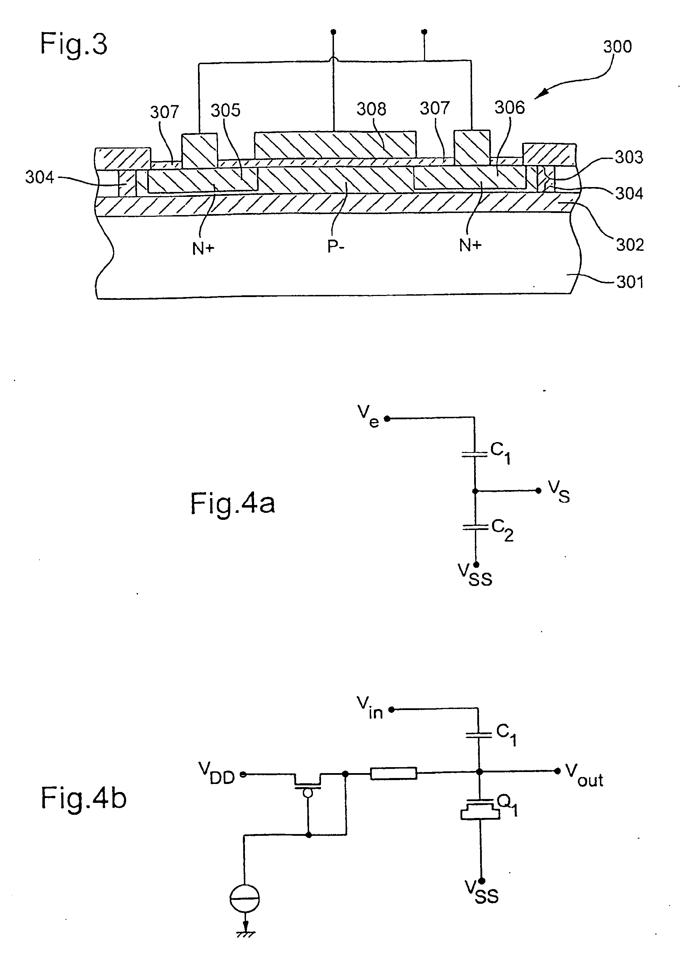

La figure 3 représente une vue en coupe d'un exemple de réalisation d'un tel transistor 300 de type SOI, tel que décrit dans le brevet US 6,172,378, auquel le lecteur intéressé peut se reporter pour obtenir plus de détails.

On distingue sur la figure 3 la structure classique simplifiée d'une puce réalisée en technologie SOI, à savoir un substrat 301, surmonté d'une couche isolante 302 réalisée par exemple en dioxyde de silicium, elle-même surmontée d'une couche de silicium 303 servant à l'intégration des composants. Des tranchées 304 remplies d'isolant sont disposées autour d'une région de ladite puce dans laquelle est intégré ledit transistor 300. La couche de silicium 303 est dopée avec des dopages différents suivant les endroits. Deux contacts métalliques sont disposés en surface de ladite région, au contact de régions dopés N+ de la seconde couche de silicium, définissant la source 305 et le drain 306 du transistor 300. Les parties libres de la seconde couche de silicium sont recouvertes d'une mince couche 307 d'oxyde, sur laquelle une couche de silicium dopé N est déposée entre la source et le drain, de manière à former la grille 308 du transistor.

Lorsque ce transistor 300 est utilisé comme condensateur, la source 305 et le drain 306 sont court-circuités formant ainsi une première borne du condensateur tandis que la grille 308 constitue la seconde borne dudit condensateur. On comprend, en observant la figure 3, qu'en fonction de la tension appliquée auxdites bornes de ce condensateur, les propriétés physiques du canal (ici de type P-, situé dans la couche 303) du transistor sont modifiées, entraînant une modification de la valeur correspondante de la capacité.

Bien entendu, la description du transistor qui précède s'applique aussi bien à un transistor de type P présentant une structure analogue à celle visible sur la figure 3 à de petites différences près, notamment au niveau des zones de dopage.

La figure 4a représente un schéma électrique d'un pont diviseur de tension simple, de type capacitif, comportant deux condensateurs classiques de capacités respectives $C_1$ et $C_2$ notés ci-après, respectivement, condensateur $C_1$ et condensateur $C_2$. Le condensateur $C_1$ est relié d'une part à une borne d'entrée par laquelle est appliqué un signal d'entrée $V_e$ et d'autre part à une première borne du condensateur $C_2$ dont la seconde borne est reliée à un potentiel fixé $V_{SS}$. Une borne de sortie est disposée entre les deux condensateurs par laquelle on récupère le signal de sortie $V_s$. Par un calcul simple, on peut déterminer la fonction de transfert k de ce circuit qui vaut:

$$k=V_s/V_e=C_1/(C_1+C_2).$$

La figure 4b représente un schéma électrique d'un pont diviseur de tension similaire à celui de la figure 4a, dans lequel le condensateur $C_2$ a été remplacé par un transistor $Q_1$, de manière à former un condensateur de capacité $C_{T1}$, tel que celui représenté sur la figure 3. On constate qu'en outre une partie supplémentaire apparaît sur le schéma de la figure 4b, correspondant à un circuit conventionnel de polarisation du transistor, qui ne sera pas décrit plus en détails dans la présente demande. Pour ce circuit, la fonction de transfert H1 devient:

$$H1=V_s/V_e=C_1/(C_1+C_{T1}).$$

Comme cela a été mentionné plus haut, lorsque la différence de potentiels $V_{DD}-V_{SS}$ varie, la valeur de $C_{T1}$ varie et donc la valeur de H1 varie également.

On a représenté, sur la figure 5, la courbe donnant le comportement de H1 en fonction de $V_{DD}-V_{SS}$ pour une valeur de tension d'entrée $V_e$ fixée. On constate que pour les valeurs de $V_{DD}-V_{SS}$ inférieures à $V_T$, ce qui correspond à un état bloqué pour le transistor $Q_1$, la fonction de transfert H1 du pont diviseur de tension est constante et égale à la valeur $h_1$. On peut constater en outre que lorsque la valeur de $V_{DD}-V_{SS}$ augmente à partir de $V_T$ jusqu'à une valeur notée $V_{C2}$, ce qui correspond à la zone de transition du transistor $Q_1$, la valeur de H1 diminue progressivement jusqu'à être à nouveau constante et égale à une valeur $h_2$ après $V_{C2}$, lorsque le transistor se trouve en régime permanent. On distingue ainsi trois portions sur la courbe de la figure 5, la portion 501 correspondant aux valeurs de $V_{DD}-V_{SS}$ inférieures à $V_T$, la portion 502 correspondant aux valeurs de $V_{DD}-V_{SS}$ comprises entre $V_T$ et $V_{C2}$ et la portion 503 correspondant aux valeurs de $V_{DD}$-$V_{SS}$ supérieures à $V_{C2}$.

Il est possible de définir plus ou moins précisément les caractéristiques de fonctionnement des composants semi-conducteurs, tels que le transistor $Q_1$ ou le circuit d'amplification 100, à partir des caractéristiques physiques de ces composants, ajustées lors de leur fabrication. Par conséquent, il est également possible de définir ces caractéristiques physiques de telle sorte que les tensions de seuil $V_T$ soient sensiblement les mêmes pour le transistor $Q_1$ et pour les composants du circuit d'amplification 100 et de telle sorte que $V_{C1}$ soit sensiblement égal à $V_{C2}$. Ainsi, les portions 202 de la courbe représentée sur la figure 2 et 502 de la courbe représentée sur la figure 5 sont superposées et l'augmentation progressive du gain du circuit d'amplification est au moins partiellement compensée par la diminution progressive de l'amplitude du signal sortant du circuit de division de tension. De cette façon, la fonction de transfert du système complet, comportant successivement ledit circuit de division de tension et le circuit d'amplification, présente une valeur sensiblement constante sur une grande partie de la plage des valeurs de $V_{DD}$-$V_{SS}$ correspondant au régime transitoire des composants semi-conducteurs. Il est en outre plus aisé d'ajuster avec une bonne précision la valeur de la capacité du condensateur de telle sorte que la compensation soit quasi-parfaite au moins dans la dernière partie de la portion de courbe 202 située du côté de la portion 203.

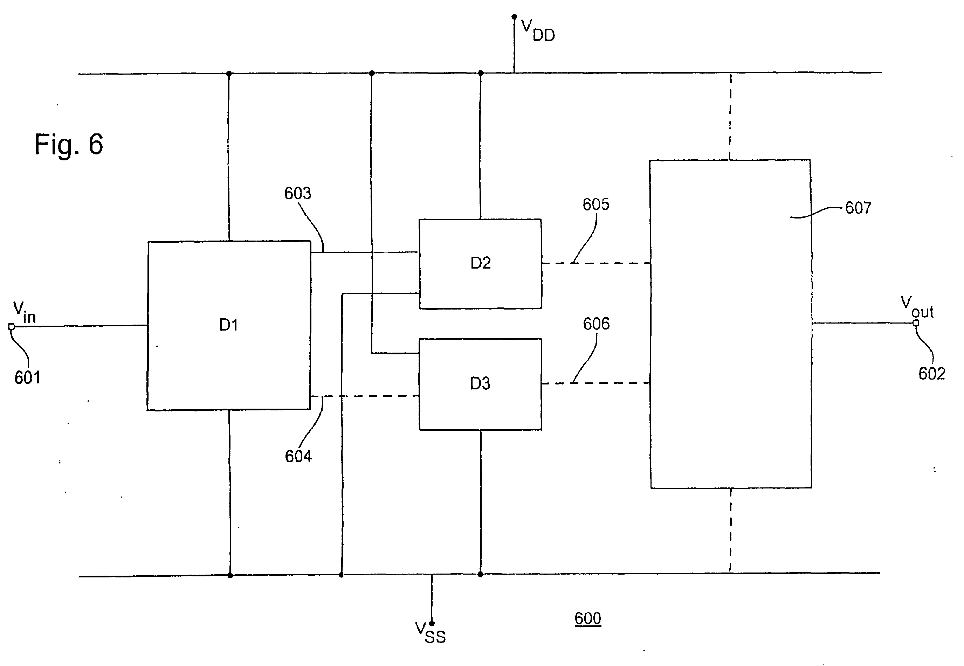

Cette particularité permet de définir une structure générale pour le système électronique 600 selon la présente invention, représentée sur la figure 6. Ledit système électronique 600 comporte au moins une borne d'entrée 601 susceptible de recevoir un signal d'entrée $V_{in}$, une borne de sortie 602 délivrant un signal de sortie $V_{out}$, une borne d'alimentation haute portée à un potentiel $V_{DD}$ et une borne d'alimentation basse portée à un potentiel $V_{SS}$. Le système comprend en outre un premier dispositif électronique, noté D1, relié notamment à la borne d'entrée 601 du système 600 et auxdites bornes d'alimentation. Le dispositif D1 comporte notamment un circuit électronique du type présentant une caractéristique analogue à celle représentée sur la figure 5, donc par exemple, au moins un étage de division de tension tel que celui représenté sur la figure 4b. Le dispositif D1 comporte en outre une borne de sortie 603 reliée à un second dispositif électronique, repéré par la référence D2 et connecté aux bornes d'alimentation du système 600. Le dispositif D2 comporte notamment un circuit électronique du type présentant une caractéristique analogue à celle représentée sur la figure 2, donc par exemple, un étage d'amplification tel que celui représenté sur la figure 1, ou encore un oscillateur de type conventionnel (non représenté).

Le système électronique 600 peut également comporter un troisième dispositif électronique, noté D3, relié à une seconde borne de sortie 604 du premier dispositif électronique D1 et aux bornes d'alimentation du système 600. Le dispositif D3 comporte un circuit électronique du même type que celui décrit ci-dessus en relation avec le second dispositif électronique D2 et le dispositif D1 comporte préférablement un circuit électronique supplémentaire présentant également une caractéristique analogue à celle représentée sur la figure 5. Dans ce cas, les dispositifs D2 et D3 comprennent respectivement au moins une borne de sortie, respectivement repérées par les références numériques 605 et 606, définissant deux bornes de sortie pour le système 600. Il est toutefois possible d'ajouter un étage de sortie 607, éventuellement connecté aux bornes d'alimentation du système 600, permettant d'effectuer la combinaison des signaux issus des bornes de sortie 605 et 606, de façon à définir un signal de sortie unique $V_{out}$.

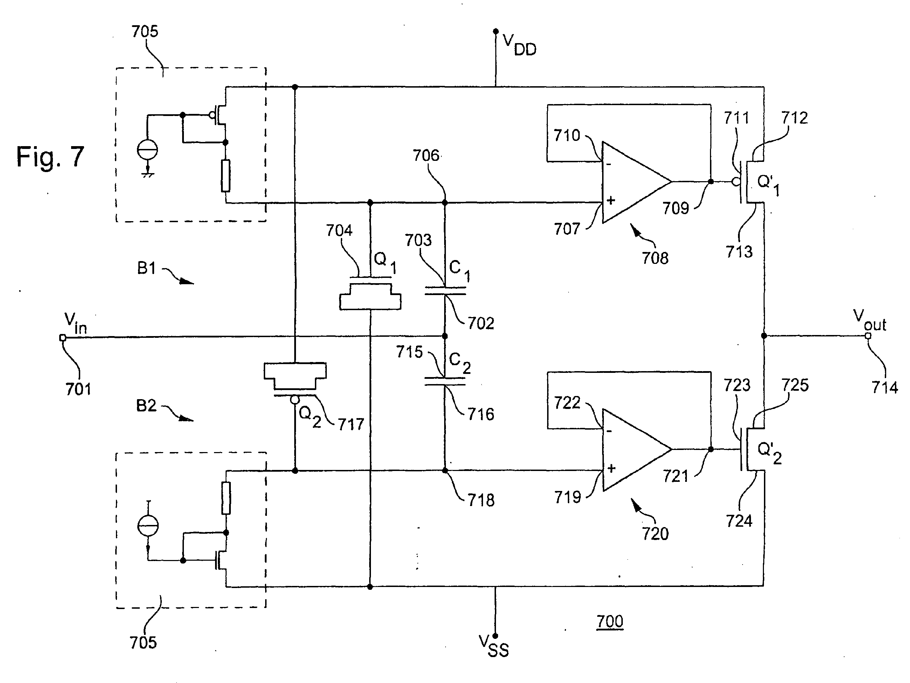

La structure générale du système électronique représentée sur la figure 6 a été mise à profit pour concevoir le système électronique 700 assurant une amplification à gain constant selon le mode de réalisation de l'invention représenté sur la figure 7. Il est important de noter que l'exemple de réalisation représenté sur la figure 7 a délibérément été choisi pour sa simplicité de manière à rendre apparent l'essentiel de la présente invention. Dans le mode de réalisation décrit ici uniquement à titre d'exemple illustratif, le système d'amplification à gain constant comporte deux sous-circuits notés $B_1$ et $B_2$ ayant tous deux pour entrée l'entrée principale 701 du système.

L'entrée du sous-circuit $B_1$ est connectée à une première borne 702 d'un condensateur $C_1$ dont la seconde borne 703 est connectée à la grille 704 d'un transistor $Q_1$, de type N et préférablement similaire à celui représenté sur la figure 3. La grille 704 du transistor $Q_1$ est en outre reliée à des moyens de polarisation 705, tels que ceux représentés sur la figure 4b par exemple. La source et le drain du transistor $Q_1$ sont court-circuités et reliés au potentiel bas $V_{SS}$ d'une source d'alimentation (non représentée). Le condensateur $C_1$ et le transistor $Q_1$, qui assure ici la fonction d'un condensateur, forment ainsi un pont diviseur de tension capacitif dont la sortie 706, située entre ladite seconde borne 703 dudit condensateur et la grille 704 du transistor $Q_1$, est connectée à une première entrée 707 d'un étage d'amplification 708 tel que celui représenté sur la figure 1. La sortie 709 dudit étage d'amplification 708 est bouclée sur sa seconde entrée 710 de manière à former une boucle de contre-réaction et est connectée en outre à la grille 711 d'un second transistor $Q'_1$ de type P. La source 712 du transistor $Q'_1$ est reliée au potentiel haut $V_{DD}$ de la source d'alimentation tandis que son drain 713 est relié à la borne de sortie 714 du système d'amplification.

La structure du sous-circuit $B_2$ présente une certaine symétrie par rapport à celle du sous-circuit $B_1$. En effet, l'entrée 701 du sous-circuit $B_2$ est connectée à une première borne 715 d'un condensateur $C_2$ dont la seconde borne 716 est connectée à la grille 717 d'un transistor $Q_2$, de type P et préférablement symétrique par rapport au transistor $Q_1$. La grille 717 du transistor $Q_2$ est en outre reliée à des moyens de polarisation 705 de même que le transistor $Q_1$. La source et le drain du transistor $Q_2$ sont court-circuités et reliés au potentiel haut $V_{DD}$ de la source d'alimentation. Le condensateur $C_2$ et le transistor $Q_2$, qui assure ici la fonction d'un condensateur, forment ainsi un pont diviseur de tension capacitif dont la sortie 718, située entre ladite seconde borne 716 dudit condensateur et la grille 717 du transistor, est connectée à une première entrée 719 d'un étage d'amplification 720 similaire à celui utilisé dans le sous-circuit $B_1$. La sortie 721 dudit étage d'amplification est bouclée sur sa seconde entrée 722 de manière à former une boucle de contre-réaction et est connectée en outre à la grille 723 d'un quatrième transistor $Q'_2$ de type N. La source 724 du transistor $Q'_2$ est reliée au potentiel bas $V_{SS}$ de la source d'alimentation tandis que son drain 725 est relié à la borne de sortie 714 du système d'amplification.

On peut noter que les étages d'amplification 708 et 720 respectifs sont ici représentés comme des montages suiveurs pour des raisons de simplification, mais bien entendu, l'homme du métier n'aura aucun mal à adapter ces étages de manière à obtenir des étages d'amplification de gain prédéfini.

Un signal d'entrée $V_{in}$ du système d'amplification 700 selon l'invention est scindé en deux composantes $S_1$ et $S_2$ respectivement traitées simultanément par lesdits deux sous-circuits $B_1$ et $B_2$. La tension d'alimentation $V_{DD}$-$V_{SS}$ étant fixée par exemple à $4V_T$, $V_T$ étant la tension de seuil préférablement commune à tous les transistors employés dans le circuit d'amplification, les composantes $S_1$ et $S_2$ sont atténuées en passant dans les ponts de division de tension respectifs. Les fractions correspondantes des composantes $S_1$ et $S_2$ sont ensuite respectivement injectées dans les premières entrées des étages d'amplification respectifs pour y être amplifiées. Les fractions amplifiées correspondantes desdites composantes $S_1$ et $S_2$ sont alors combinées à travers, respectivement, les transistors $Q'_1$ et $Q'_2$ pour donner, en sortie du système d'amplification 700, un signal unique de sortie $V_{out}$ correspondant simplement au signal d'entrée amplifié avec un gain d'amplification H3.

D'après la description précédente de la courbe 2, on peut se rendre compte que si on fixe à présent la tension d'alimentation d'un circuit d'alimentation selon l'art antérieur à $2V_T$, le point de fonctionnement du système se situe dans la zone de transition 202 et le gain en amplification du système n'est plus le même que pour une tension d'alimentation de $4V_T$.

Toutefois, grâce aux caractéristiques du système d'amplification selon l'invention, une tension d'alimentation même légèrement inférieure à $2V_T$ est suffisante pour obtenir un gain d'amplification H3 sensiblement égal au gain obtenu avec une tension d'alimentation fixée à $4V_T$, par exemple.

Ce résultat est apparent des courbes a et b représentées sur la figure 8 présentant le comportement du gain d'amplification H3 en fonction de la variation de la tension d'alimentation du système d'amplification, respectivement selon l'art antérieur et selon la présente invention.

Comme cela a été mentionné ci-dessus, on constate sur la courbe a de la figure 8 que le gain d'amplification du circuit selon l'art antérieur devient constant à partir d'une valeur de $V_{DD}$-$V_{SS}$ supérieure à $V_{C1}$ qui est ici supérieure à $2V_T$. D'autre part, on constate sur la courbe b de la figure 8 que le gain d'amplification selon la présente invention devient constant à partir d'une valeur de $V_{DD}$-$V_{SS}$ supérieure à $V_{C3}$ qui est ici inférieure à $2V_T$.

Par conséquent, on en déduit que l'avantage en termes de tension d'alimentation du système d'amplification selon l'invention par rapport aux circuits de l'art antérieur vaut $\Delta V = V_{C1} - V_{C3}$.

Concrètement, cet avantage se traduit par une économie de l'ordre de 0,5 à 1 Volt sur la tension d'alimentation du système d'amplification selon la présente invention, ce qui le rend particulièrement bien adapté pour des applications nécessitant de faibles consommation d'énergie, tel que dans les appareils portables.

La description qui précède correspond à un mode de réalisation préféré de l'invention et ne saurait en aucun cas être considérée comme limitative, en ce qui concerne par exemple la nature des éléments servant à effectuer l'amplification du signal, le type de technologie employé pour intégrer les composants ou encore les composants employés en sortie des étages d'amplification permettant de combiner les signaux provenant des deux sous-circuits $B_1$ et $B_2$ pour obtenir un signal de sortie $V_{out}$ unique.

Il est bien entendu possible de mettre à profit l'enseignement de la présente invention pour effectuer une amplification asymétrique d'un signal d'entrée en choisissant par exemple de fixer les gains respectifs des deux étages d'amplification à des valeurs différentes.

Les applications possibles du système électronique selon l'invention sont nombreuses et l'homme du métier saura bien entendu procéder aux adaptations nécessaires à son intégration dans un système plus général, tel que dans un circuit oscillateur par exemple. On pourra notamment envisager l'utilisation d'un tel système pour réaliser un oscillateur permettant de réguler la marche d'une montre électromécanique alimentée par une microgénératrice, par exemple du type décrit dans les documents CH 597 636, EP 0 239 820 ou encore EP 0 679 968.

**Revendications**

1.  Système électronique (600, 700) comportant au moins un premier dispositif électronique (D1) à composants semi-conducteurs alimenté par une tension d'alimentation ($V_{DD}$-$V_{SS}$) entre des première et seconde bornes d'alimentation ($V_{DD}$, $V_{SS}$), le premier dispositif recevant un signal d'entrée par au moins une borne d'entrée (601, 701), et fournissent un signal de sortie par une borne de sortie (602, 714), **caractérisé en ce que** ledit dispositif électronique (D1) est configuré de manière à présenter un gain en tension (H1) entre le signal de sortie et le signal d'entrée dont la représentation graphique en fonction de ladite tension d'alimentation comporte trois domaines successifs, la premier domaine (501) s'étendent pour des valeurs de tension d'alimentation ($V_{DD}$-$V_{SS}$) inférieure ou égale à une valeur de tension de seuil ($V_T$) des composants semi-conducteurs, ledit domaine (501) correspondant à une première valeur (h1) constante du gain (H1) le second domaine (502) s'étendant depuis la valeur de tension de seuil ($V_T$) jusqu'à une valeur ($V_{C2}$). correspondant à une diminution progressive du gain (H1) et le troisième domaine (503) s'étendant au-dessus de cette valeur ($V_{C2}$) correspondant à une seconde valeur (h2) constante du gain (H1) inférleure à la première valeur (h1) constante du gain (H1).

2. Système élactonique (600, 700) selon la revendication 1, dont la borne de sortie du premier dispositif électronique (D1) est connectée a un second dispositif électronique (D2) à composants semi-conducteurs également alimenté par la tension d'alimentation ($V_{DD}$-$V_{SS}$) entre des première et seconde bornes d'alimentation et configuré pour présenter un gain en tension (H2) dont la représentation graphique en fonction de la tension d'alimentation comporte trois domaines successifs, le premier domaine (201) s'étendant pour des valeurs de ($V_{DD}$-$V_{SS}$) inférieure ou égale à une valeur ($V_T$) de tension de seuil des composants semi-conducters, ledit domaine correspondant à une première valeur constante du gain (H2), le second domaine (202) s'étendant depuis ($V_T$) jusqu'à une valeur ($V_{C1}$), correspondant à une augmentation progressive du gain (H2), et le troisième domaine (203) s'étendant au-dessus de ($V_{C1}$), correspondant à une seconde valeur constante du gain (H2) et plus grande que la première valeur du gain (H2), **caractérisé en ce que** ledit premier dispositif électronique (D1) est configuré pour présenter un gain en tension (H1) variant en fonction de la tension d'alimontation ($V_{DD}$-$V_{SS}$), de telle manière que le système électronique (600, 700) présente un gain en tension (H3) variant en fonction de la tension d'alimentation ($V_{DD}$-$V_{SS}$) de façon à être constant à partir d'une valeur de tension d'alimentation ($V_{C3}$) inférieure à ($V_{C1}$).

3. Système électronique (600, 700) selon l'une des revendications 1 ou 2, **caractérisé en ce que** ledit premier dispositif (D1) comporte au moins un circuit de division de tension de type capacitif connecté d'une part à une première desdites deux bornes d'alimentation et d'autre part à ladite borne d'entrée, et **en ce que** ledit circuit de division de tension comporte au moins un élément capacitif (Q1, Q2) à capacité variable.

4. Système électronique (600, 700) selon la revendication 3, **caractérisé en ce que** ledit élément capacitif à capacité variable (Q1, Q2) est un transistor comprenant une grille (308, 704, 717) reliée notamment à ladite borne de sortie (603, 604, 706, 718) dudit premier dispositif électronique (D1), une source (305) et un drain (306) connectés l'un à l'autre et reliés à ladite première borne d'alimentation.

5. Système électronique (600, 700) selon la revendication 4, **caractérisé en ce que** ledit transistor (Q1, Q2) est réalisé en technologie SOI.

6. Système électronique (600, 700) selon l'une des revendications 4 ou 5, **caractérisé en ce que** ledit premier dispositif (D1) comprend également des moyens de polarisation (705) dudit transistor (Q1, Q2) reliés d'une part à la seconde desdites deux bornes d'alimentation et d'autre part à la grille (308, 704, 717) dudit transistor.

7. Système électronique (600, 700) selon la revendication 2, **caractérisé en ce que** ledit second dispositif électronique (D2) comprend au moins un circuit électronique pris dans le groupe comprenant les amplificateurs et les oscillateurs à composants semi-conducteurs.

8. Système électronique (600, 700) selon l'une des revendications 4 à 6, **caractérisé en ce que** ledit transistor (Q1, Q2) est de type N, et **en ce que** sa source (305) et son drain (306) sont reliés à ladite borne d'alimentation de potentiel bas de la tension d'alimentation.

9. Système électronique (600, 700) selon l'une des revendications 4 à 6, **caractérisé en ce que** ledit transistor (Q1, Q2) est de type P, et **en ce que** sa source (305) et son drain (306) sont reliés à ladite borne d'alimentation de potentiel haut de la tension d'alimentation.

10. Système électronique (600, 700) selon la revendication 6, **caractérisé en ce que** ledit premier dispositif (D1) comporte en outre une seconde borne de sortie (604, 718), un second circuit de division de tension de type capacitif connecté d'une part à la seconde desdites deux bornes d'alimentation et d'autre part à ladite borne d'entrée (601, 701), **en ce que** ledit second circuit de division de tension comporte au moins un second transistor (Q2) de type SOI dont le type de dopage est différent de celui du transistor dudit premier circuit et comprenant une grille (717) reliée notamment à ladite seconde borne de sortie (604, 718), une source (305) et un drain (306) connectés l'un à l'autre et reliés à ladite seconde borne d'alimentation, et **en ce que** ledit premier dispositif (D1) comprend également des moyens de polarisation (705) dudit second transistor (Q2) reliés d'une part à la première desdites deux bonnes d'alimentation et d'autre part à la grille (717) dudit second transistor (Q2).

**11.** Système électronique (600, 700) selon la revendication 10, **caractérisé en ce que** ledit transistor (Q1) du premier circuit de division de tension est de type N, sa source et son drain étant reliés à la borne d'alimentation de potentiel bas ($V_{SS}$) de la tension d'alimentation et ses moyens de polarisation (705) étant notamment reliés à la borne d'alimentation de potentiel haut ($V_{DD}$) de la tension d'alimentation, tandis que ledit transistor (Q2) dudit second circuit de division de tension est de type P, sa source et son drain étant reliés à la borne d'alimentation de potentiel haut de la tension d'alimentation et ses moyens de polarisation (705) étant notamment reliés à la borne d'alimentation de potentiel bas de la tension d'alimentation et **en ce que** les moyens de polarisation du transistor (Q1) dudit premier circuit de division de tension comprennent notamment une source de courant et un transistor de type P dont la grille et la source sont connectées l'une à l'autre et reliées simultanément à une première borne de ladite source de courant et à ladite borne d'alimentation de potentiel haut de la tension d'alimentation, la seconde borne de ladite source de courant étant reliée à ladite borne d'alimentation de potentiel bas de la tension d'alimentation, et **en ce que** les moyens de polarisation (705) du transistor (Q2) dudit second circuit de division de tension comprennent notamment une source de courant et un transistor de type N dont la grille et le drain sont connectés l'un à l'autre et reliés simultanément à une première borne de ladite source de courant et à ladite borne d'alimentation de potentiel bas de la tension d'alimentation, la seconde borne de ladite source de courant étant reliée à ladite borne d'alimentation de potentiel haut de la tension d'alimentation.

**12.** Système électronique (600, 700) selon l'une des revendications 10 ou 11, **caractérisé en ce qu'**il comporte en outre un étage de sortie (607, Q'1, Q'2) comprenant deux bornes d'entrée (605, 606, 709, 721) et une borne de sortie (602, 714), lesdites deux bornes d'entrée étant respectivement connectées auxdites deux bornes de sortie (603, 604, 706, 718) dudit premier dispositif électronique (D1) de manière à délivrer à la borne de sortie (602, 714) dudit étage de sortie (607, Q'1, Q'2) un signal ($V_{out}$) correspondant à la recombinaison des signaux délivrés par lesdites deux bornes respectives (603, 604, 706, 718) du premier dispositif électronique (D1).

**13.** Système électronique (600, 700) selon la revendication 10, **caractérisé en ce qu'**un circuit électronique du second dispositif (D2) comporte notamment une borne d'entrée (707) et une borne de sortie (709), ladite borne d'entrée étant connectée à une première (603, 706) desdites deux bornes de sortie dudit premier dispositif (D1).

**14.** Système électronique (600, 700) selon la revendication 13, **caractérisé en ce qu'**il comporte en outre un troisième dispositif électronique D3 comprenant notamment un second circuit électronique pris dans le groupe comprenant les amplificateurs et les oscillateurs, ledit second circuit électronique comportant une borne d'entrée (719) et une borne de sortie (721), ladite borne d'entrée étant connectée à la seconde (604, 718) desdites deux bornes de sortie dudit premier dispositif électronique (D1).

**15.** Système électronique (600, 700) selon l'une des revendications 13 ou 14, **caractérisé en ce qu'**il comporte en outre un étage de sortie (607) comprenant notamment deux bornes d'entrée (605, 606, 709, 721) et une borne de sortie (602, 714), lesdites bornes d'entrée (605/709, 606/721) étant respectivement connectées aux bornes de sortie (605, 606, 709, 721) des second et troisième dispositifs (D2, D3), ledit étage de sortie (607) assurant la recombinaison des signaux respectivement délivrés par lesdites deux bornes de sortie.

**16.** Système électronique (600, 700) selon l'une des revendications 12 ou 15, **caractérisé en ce que** ledit étage de sortie (607) comprend au moins deux transistors (Q'1, Q'2) dont les grilles (711, 723) sont respectivement connectées auxdites bornes d'entrée (605, 606, 709, 721) de l'étage de sortie, les sources sont respectivement connectées auxdites bornes d'alimentation du système et les drains sont connectés à ladite borne de sortie (602, 714) dudit étage de sortie.

**17.** Système électronique selon la revendication 3, ledit circuit de division étant connecté d'une part à une borne d'entrée ($V_{in}$) et d'autre part à une borne portée à un premier potentiel de référence ($V_{SS}$, $V_{DD}$), le circuit comportant une borne de sortie ($V_{out}$), **caractérisé en ce qu'**il comporte un transistor (Q1) de type SOI comprenant une grille (308) reliée notamment à ladite borne de sortie ($V_{out}$) du circuit, une source (305) et un drain (306) connectés l'un à l'autre et reliés à ladite borne portée audit premier potentiel de référence ($V_{SS}$, $V_{DD}$) et **en ce qu'**il comporte en outre des moyens de polarisation (705) dudit transistor connectés d'une part à la grille dudit transistor et d'autre part à une borne portée à un second potentiel de référence ($V_{SS}$, $V_{DD}$).

**18.** Système électronique selon la revendication 17, **ca-**

**ractérisé en ce que** ledit transistor (Q1) est de type N, **en ce que** ladite borne portée à un premier potentiel de référence est une borne d'alimentation de potentiel bas d'une tension d'alimentation ($V_{SS}$), **en ce que** ladite borne portée à un second potentiel de référence est une borne d'alimentation de potentiel haut d'une tension d'alimentation ($V_{DD}$), et **en ce que** lesdits moyens de polarisation (705) du transistor comprennent notamment une source de courant et un transistor de type P dont la source et la grille sont connectées l'une à l'autre et reliées à ladite source de courant.

19. Système électronique selon la revendication 17, **caractérisé en ce que** ledit transistor (Q2) est de type P, **en ce que** ladite borne portée à un premier potentiel de référence est une borne d'alimentation de potentiel haut d'une tension d'alimentation ($V_{DD}$), **en ce que** ladite borne portée à un second potentiel de référence est une borne d'alimentation de potentiel bas d'une tension d'alimentation ($V_{SS}$), et **en ce que** lesdits moyens de polarisation (705) du transistor comprennent notamment une source de courant et un transistor de type N dont le drain et la grille sont connectés l'un à l'autre et reliées à ladite source de courant.

**Claims**

1. Electronic system (600, 700) including at least a first electronic device (D1) with semiconductor components supplied by a supply voltage ($V_{DD}$-$V_{SS}$) between first and second supply terminals ($V_{DD}$, $V_{SS}$), the first device receiving an input signal by at least an input terminal (601, 701), and furnishing an output signal by an output terminal (602, 714), **characterized in that** said electronic device (D1) is shaped in order to present a voltage gain (H1) between the output signal and the input signal, the graphic representation of which as a function of said supply voltage includes three successive ranges, the first range (501) ranging from low values of supply voltage ($V_{DD}$-$V_{SS}$) to a value, called the threshold voltage ($V_T$) of the semiconductor components, said range (501) corresponding to a first value (h1) of (H1) that is high and substantially constant, the second range (502) ranging from the value of the threshold voltage ($V_T$) to a value ($V_{C2}$), corresponding to a sharply sloping decrease in (H1) and the third range (503) extending beyond this value ($V_{C2}$), corresponding to a value (h2) of (H1) that is low and substantially constant.

2. Electronic system (600, 700) according to claim 1, whose output terminal of the first electronic device (D1) is connected to a second electronic device (D2) with semiconductor components also powered by the voltage ($V_{DD}$-$V_{SS}$) between first and second terminals and shaped in order to present a voltage gain (H2) the graphic representation of which as a function of the supply voltage includes three successive ranges, the first range (201) ranging from low values of ($V_{DD}$-$V_{SS}$) to a value ($V_T$), called the threshold voltage of the semiconductor components, said first range corresponding to a low and substantially constant value of (H2), the second range (202) ranging from ($V_T$) to a value ($V_{C1}$), corresponding to a sharply sloping increase in (H2) and the third range (203) extending beyond ($V_{C1}$), corresponding to a high and substantially constant value of (H2), **characterized in that** said first electronic device (D1) is shaped in order to present a voltage gain (H1) that varies as a function of the supply voltage ($V_{DD}$-$V_{SS}$), such that the electronic system (600, 700) has a voltage gain (H3) that varies as a function of the supply voltage ($V_{DD}$-$V_{SS}$) so as to be substantially constant from a value of supply voltage ($V_{C3}$) lower than $V_{C1}$).

3. Electronic system (600, 700) according to claims 1 or 2, **characterized in that** said first device (D1) includes at least a capacitive type voltage divider stage connected on the one hand to a first of said two supply terminals and on the other hand, to said input terminal, and **in that** said voltage divider stage includes at least a capacitive element (Q1, Q2) with variable capacitance.

4. Electronic system (600, 700) according to claim 3, **characterized in that** said capacitive element with variable capacitance (Q1, Q2) is a transistor including a gate (308, 704, 717) connected, in particular, to said output terminal (603, 604, 706, 718) of said first electronic device D1, a source (305) and a drain (306) connected to each other and connected to said first supply terminal.

5. Electronic system (600, 700) according to claim 4, **characterized in that** said transistor (Q1, Q2) is made in SOI technology.

6. Electronic system (600, 700) according to claims 4 or 5, **characterized in that** said first device (D1) also includes polarisation means (705) for said transistor (Q1, Q2) connected on the one hand to the second of said two supply terminals and on the other hand to the gate (308, 704, 717) of said transistor.

7. Electronic system (600, 700) according to claim 2, **characterized in that** said second electronic device (D2) includes at least an electronic circuit taken from the group including amplifiers and oscillators with semiconductor components.

8. Electronic system (600, 700) according to any of claims 4 to 6, **characterized in that** said transistor (Q1, Q2) is of the N type and **in that** its source (305) and its drain (306) are connected to said low supply terminal.

9. Electronic system (600, 700) according to any of claims 4 to 6, **characterized in that** said transistor (Q1, Q2) is of the P type and **in that** its source (305) and its drain (306) are connected to said high supply terminal.

10. Electronic system (600, 700) according to claim 6, **characterized in that** said first device (D1) further includes a second output terminal (604, 718), a second capacitive type voltage divider stage connected on the one hand to the second of said two supply terminals and on the other hand to said input terminal (601, 701), **in that** said second voltage divider stage includes at least a second SOI type transistor (Q2) whose doping type is different from that of the transistor of said first stage and including a gate (717) connected, in particular, to said second output terminal (604, 718), a source (305) and a drain (306) connected to each other and connected to said second supply terminal and **in that** said first device (D1) also includes polarisation means (705) for said second transistor (Q2) connected on the one hand to the first of said two supply terminals and on the other hand to the gate (717) of said second transistor (Q2).

11. Electronic system (600, 700) according to claim 10, **characterized in that** said transistor (Q1) of the first voltage divider stage is of the N type, its source and its drain being connected to the low supply terminal ($V_{SS}$) and its polarisation means (705) in particular being connected to the high supply terminal ($V_{DD}$) whereas said transistor (Q2) of said second voltage divider stage is of the P type, its source and its drain being connected to the high supply terminal and its polarisation means (705) being connected to the low supply terminal and **in that** the polarisation means for the transistor (Q1) of said first voltage divider stage include in particular a current source and a P type transistor whose gate and source are connected to each other and simultaneously connected to a first terminal of said current source and to said high supply terminal, the second terminal of said current source being connected to said low supply terminal, and **in that** the polarisation means (705) of the transistor (Q2) of said second voltage divider stage include in particular a current source and an N type transistor whose gate and drain are connected to each other and connected simultaneously to a first terminal of said current source and to said low supply terminal, the second terminal of said current source being connected to said high supply terminal.

12. Electronic system (600, 700) according to claims 10 or 11, **characterized in that** it further includes an output stage (607, Q'1, Q'2) including two input terminals (605, 606, 709, 721) and an output terminal (602, 714), said two input terminals being respectively connected to said two output terminals (603, 604, 706, 718) of said first electronic device D1 so as to deliver to the output terminal (602, 714) of said output stage (607, Q'1, Q'2) a signal ($V_{out}$) corresponding to the recombination of the signals delivered by said two respective terminals (603, 604, 706, 718) of the first electronic device D1.

13. Electronic system (600, 700) according to claim 10, **characterized in that** an electronic circuit of the second device (D2) includes in particular an input terminal (707) and an output terminal (709), said input terminal being connected to a first (603, 706) of said two output terminals of said first device (D1).

14. Electronic system (600, 700) according to claim 13, **characterized in that** it further includes a third electronic device D3 including in particular an electronic circuit selected from the group including amplifiers and oscillators, said second electronic circuit including an input terminal (719) and an output terminal (721), said input terminal being connected to the second (604, 718) of said two output terminals of said first electronic device (D1).

15. Electronic system (600, 700) according to claims 13 or 14, **characterized in that** it further includes an output stage (607) including in particular two input terminals (605, 606, 709, 721) and an output terminal (602, 714), said input terminals (605/709, 606/721) being respectively connected to the output terminals (605, 606, 709, 721) of the second and third devices (D2, D3), said output stage (607) performing the recombination of the signals respectively delivered by said two output terminals.

16. Electronic system (600, 700) according to claims 12 or 15, **characterized in that** said output stage (607) includes at least two transistors (Q'1, Q'2) whose gates (711, 723) are respectively connected to said input terminals (605, 606, 709, 721) of the output stage, the sources are respectively connected to said supply terminals of the system and the drains are connected to said output terminal (602, 714) of said output stage.

17. Electronic system according to claim 3, said divider circuit being connected on the one hand to an input terminal ($V_{in}$) and on the other hand to a terminal brought to a first reference potential ($V_{SS}$, $V_{DD}$), the circuit including an output terminal ($V_{out}$), **characterized in that** it includes an SOI type transistor (Q1) including a gate (308) connected in particular to said output terminal ($V_{out}$) of the circuit, a source (305) and a drain (306) connected to each other and connected to said terminal brought to said first reference potential ($V_{SS}$, $V_{DD}$) and **in that** it further includes polarisation means (705) for said transistor connected on the one hand to the gate of said transistor and on the other hand to a terminal brought to a second reference potential ($V_{SS}$, $V_{DD}$).

18. Electronic system according to claim 17, **characterized in that** said transistor (Q1) is of the N type, **in that** said terminal brought to a first reference potential is a low supply terminal ($V_{SS}$), **in that** said terminal brought to a second reference potential is a high supply terminal ($V_{DD}$) and **in that** said polarisation means (705) for the transistor include in particular a current source and a P type transistor whose source and gate are connected to each other and connected to said current source.

19. Electronic system according to claim 17, **characterized in that** said transistor (Q2) is of the P type, **in that** said terminal brought to a first reference potential is a high supply terminal ($V_{DD}$), **in that** said terminal brought to a second reference potential is a low supply terminal ($V_{SS}$) and **in that** said polarisation means (705) of the transistor include in particular a current source and an N type transistor whose drain and gate are connected to each other and connected to said current source.

## Patentansprüche

1. Elektronisches System (600, 700), das wenigstens eine erste elektronische Vorrichtung (D1) umfasst, die mit Halbleiterbauelementen versehen ist und durch eine Versorgungsspannung ($V_{DD}$-$V_{SS}$) zwischen einem ersten und einem zweiten Versorgungsanschluss ($V_{DD}$, $V_{SS}$) versorgt wird, wobei die erste Vorrichtung ein Eingangssignal über wenigstens einen Eingangsanschluss (601, 701) empfängt und über einen Ausgangsanschluss (602, 714) ein Ausgangssignal liefert, **dadurch gekennzeichnet, dass** die elektronische Vorrichtung (D1) in der Weise konfiguriert ist, dass sie zwischen dem Ausgangssignal und dem Eingangssignal eine Spannungsverstärkung (H1) aufweist, deren graphische Darstellung entsprechend der Versorgungsspannung drei aufeinanderfolgende Bereiche aufweist, wobei sich der erste Bereich (501) über Werte der Versorgungsspannung ($V_{DD}$-$V_{SS}$) kleiner oder gleich einem Schwellenspannungswert ($V_T$) der Halbleiterbauelemente erstreckt und einem ersten konstanten Wert (h1) der Verstärkung (H1) entspricht, wobei der zweite Bereich (502) von dem Schwellenspannungswert ($V_T$) bis zu einem Wert ($V_{C2}$) reicht, der einer progressiven Abnahme der Verstärkung (H1) entspricht, und wobei der dritte Bereich (503) oberhalb dieses Wertes ($V_{C2}$) liegt und einem zweiten konstanten Wert (h2) der Verstärkung (H1) entspricht, der kleiner als der erste konstante Wert (h 1) der Verstärkung (H 1) ist.

2. Elektronisches System (600, 700) nach Anspruch 1, wobei der Ausgangsanschluss der ersten elektronischen Vorrichtung (D1) mit einer zweiten elektronischen Vorrichtung (D2) verbunden ist, die mit Halbleiterbauelementen versehen ist, ebenfalls durch die Versorgungsspannung ($V_{DD}$-$V_{SS}$) zwischen dem ersten und dem zweiten Versorgungsanschluss versorgt wird und konfiguriert ist, um eine Spannungsverstärkung (H2) zu liefern, deren graphische Darstellung entsprechend der Versorgungsspannung drei aufeinanderfolgende Bereiche enthält, wobei der erste Bereich (201) Werte von ($V_{DD}$-$V_{SS}$), die kleiner oder gleich einem Spannungsschwellenwert ($V_T$) der Halbleiterbauelemente sind, enthält und einem ersten konstanten Wert der Verstärkung (H2) entspricht, wobei der zweite Bereich (202) von ($V_T$) bis zu einem Wert ($V_{C1}$) reicht und einer progressiven Erhöhung der Verstärkung (H2) entspricht, und wobei der dritte Bereich (203) über ($V_{C1}$) liegt und einem zweiten konstanten Verstärkungswert (H2) entspricht, der größer als der erste Verstärkungswert (H2) ist, **dadurch gekennzeichnet, dass** die erste elektronische Vorrichtung (D1) konfiguriert ist, um eine Spannungsverstärkung (H1) zu liefern, die sich in Abhängigkeit von der Versorgungsspannung ($V_{DD}$-$V_{SS}$) verändert, derart, dass das elektronische System (600, 700) eine Spannungsverstärkung (H3) aufweist, die sich in Abhängigkeit von der Versorgungsspannung ($V_{DD}$-$V_{SS}$) in der Weise verändert, dass sie ab einem Versorgungsspannungswert ($V_{C3}$), der kleiner als ($V_{C1}$) ist, konstant ist.

3. Elektronisches System (600, 700) nach einem der Ansprüche 1 oder 2, **dadurch gekennzeichnet, dass** die erste Vorrichtung (D1) wenigstens eine Spannungsteilerschaltung des kapazitiven Typs enthält, die einerseits mit einem ersten der zwei Versorgungsanschlüsse verbunden ist und andererseits mit dem Eingangsanschluss verbunden ist, und dass die Spannungsteilerschaltung wenigstens ein kapazitives Element (Q1, Q2) mit veränderlicher Kapazität enthält.

4. Elektronisches System (600, 700) nach Anspruch 3, **dadurch gekennzeichnet, dass** das kapazitive Element (Q1, Q2) mit veränderlicher Kapazität ein Transistor ist, der ein Gate (308, 704, 717), das insbesondere mit dem Ausgangsanschluss (603, 604, 706, 718) der ersten elektronischen Vorrichtung (D1) verbunden ist, eine Source (305) und einen Drain (306), die miteinander und mit dem ersten Versorgungsanschluss verbunden sind, enthält.

5. Elektronisches System (600, 700) nach Anspruch 4, **dadurch gekennzeichnet, dass** der Transistor (Q1, Q2) in SOI-Technologie verwirklicht ist.

6. Elektronisches System (600, 700) nach einem der Ansprüche 4 oder 5, **dadurch gekennzeichnet, dass** die erste Vorrichtung (D1) außerdem Vorspannungsmittel (705) für den Transistor (Q1, Q2) enthält, die einerseits mit dem zweiten Versorgungsanschluss und andererseits mit dem Gate (308, 704, 717) des Transistors verbunden sind.

7. Elektronisches System (600, 700) nach Anspruch 2, **dadurch gekennzeichnet, dass** die zweite elektronische Vorrichtung (D2) wenigstens eine elektronische Schaltung enthält, die aus der Gruppe gewählt ist, die Verstärker und Oszillatoren mit Halbleiterbauelementen umfasst.

8. Elektronisches System (600, 700) nach einem der Ansprüche 4 bis 6, **dadurch gekennzeichnet, dass** der Transistor (Q1, Q2) vom Typ N ist und dass seine Source (305) und sein Drain (306) mit dem Versorgungsanschluss auf niedrigem Potential der Versorgungsspannung verbunden sind.

9. Elektronisches System (600, 700) nach einem der Ansprüche 4 bis 6, **dadurch gekennzeichnet, dass** der Transistor (Q1, Q2) vom Typ P ist und dass seine Source (305) und sein Drain (306) mit dem Versorgungsanschluss auf hohem Potential der Versorgungsspannung verbunden sind.

10. Elektronisches System (600, 700) nach Anspruch 6, **dadurch gekennzeichnet, dass** die erste Vorrichtung (D1) außerdem einen zweiten Ausgangsanschluss (604, 718), eine zweite Spannungsteilerschaltung des kapazitiven Typs, die einerseits mit dem zweiten Versorgungsanschluss und andererseits mit dem Eingangsanschluss (601, 701) verbunden ist, umfasst, dass die zweite Spannungsteilerschaltung wenigstens einen zweiten Transistor (Q2) des SOI-Typs enthält, dessen Dotierungstyp von jenem des Transistors der ersten Schaltung verschieden ist und der ein Gate (717), das insbesondere mit dem zweiten Ausgangsanschluss (604, 718) verbunden ist, eine Source (305) und einen Drain (306), die miteinander und mit dem zweiten Versorgungsanschluss verbunden sind, enthält und dass die erste Vorrichtung (D1) außerdem Vorspannungsmittel (705) für den zweiten Transistor (Q2) enthält, die einerseits mit dem ersten Versorgungsanschluss und andererseits mit dem Gate (717) des zweiten Transistors (Q2) verbunden sind.

11. Elektronisches System (600, 700) nach Anspruch 10, **dadurch gekennzeichnet, dass** der Transistor (Q1) der ersten Spannungsteilerschaltung vom Typ N ist, wobei seine Source und sein Drain mit dem Versorgungsanschluss auf niedrigem Potential ($V_{SS}$) der Versorgungsspannung verbunden sind und seine Vorspannungsmittel (705) insbesondere mit dem Versorgungsanschluss auf hohem Potential ($V_{DD}$) der Versorgungsspannung verbunden sind, während der Transistor (Q2) der zweiten Spannungsteilerschaltung vom Typ P ist, wobei seine Source und sein Drain mit dem Versorgungsanschluss auf hohem Potential der Versorgungsspannung verbunden sind und seine Vorspannungsmittel (705) insbesondere mit dem Versorgungsanschluss auf niedrigem Potential der Versorgungsspannung verbunden sind, und dass die Vorspannungsmittel des Transistors (Q1) der ersten Spannungsteilerschaltung insbesondere eine Stromquelle und einen Transistor des Typs P umfassen, dessen Gate und dessen Source miteinander und gleichzeitig mit einem ersten Anschluss der Stromquelle und mit dem Versorgungsanschluss auf hohem Potential der Versorgungsspannung verbunden sind, wobei der zweite Anschluss der Stromquelle mit dem Versorgungsanschluss auf niedrigem Potential der Versorgungsspannung verbunden ist, und dass die Vorspannungsmittel (705) des Transistors (Q2) der zweiten Spannungsteilerschaltung insbesondere eine Stromquelle und einen Transistor des Typs N enthalten, dessen Gate und dessen Drain miteinander und gleichzeitig mit einem ersten Anschluss der Stromquelle und mit dem Versorgungsanschluss auf niedrigem Potential der Versorgungsspannung verbunden sind, wobei der zweite Anschluss der Stromquelle mit dem Versorgungsanschluss auf hohem Potential der Versorgungsspannung verbunden ist.

12. Elektronisches System (600, 700) nach einem der Ansprüche 10 oder 11, **dadurch gekennzeichnet, dass** es außerdem eine Ausgangsstufe (607, Q'1, Q'2) enthält, die zwei Eingangsanschlüsse (605, 606, 709, 721) und einen Ausgangsanschluss (602, 714) umfasst, wobei die zwei Eingangsanschlüsse entsprechend mit den zwei Ausgangsanschlüssen (603, 604, 706, 718) der ersten elektronischen Vorrichtung (D1) verbunden sind, derart, dass am Ausgangsanschluss (602, 714) der Ausgangsstufe (607, Q'1, Q'2) ein Signal ($V_{out}$) geliefert wird, das der Rekombination der Signale entspricht, die von den zwei jeweiligen Anschlüssen (603, 604, 706, 718) der ersten elektronischen Vorrichtung (D1) geliefert werden.

13. Elektronisches System (600, 700) nach Anspruch 10, **dadurch gekennzeichnet, dass** eine elektronische Schaltung der zweiten Vorrichtung (D2) insbesondere einen Eingangsanschluss (707) und einen Ausgangsanschluss (709) umfasst, wobei der Eingangsanschluss mit dem ersten Ausgangsanschluss (603, 706) der ersten Vorrichtung (D1) verbunden ist.

**14.** Elektronisches System (600, 700) nach Anspruch 13, **dadurch gekennzeichnet, dass** es außerdem eine dritte elektronische Vorrichtung D3 umfasst, die insbesondere eine zweite elektronische Schaltung enthält, die aus der Gruppe ausgewählt ist, die Verstärker und Oszillatoren umfasst, wobei die zweite elektronische Schaltung einen Eingangsanschluss (719) und einen Ausgangsanschluss (721) aufweist, wobei der Eingangsanschluss mit dem zweiten Ausgangsanschluss (604, 718) der ersten elektronischen Vorrichtung (D1) verbunden ist.

**15.** Elektronisches System (600, 700) nach einem der Ansprüche 13 oder 14, **dadurch gekennzeichnet, dass** es außerdem eine Ausgangsstufe (607) umfasst, die insbesondere zwei Eingangsanschlüsse (605, 606, 709, 721) und einen Ausgangsanschluss (602, 714) aufweist, wobei die Eingangsanschlüsse (605/709, 606/721) mit entsprechenden Ausgangsanschlüssen (605, 606, 709, 721) der zweiten bzw. der dritten Vorrichtung (D2, D3) verbunden sind, wobei die Ausgangsstufe (607) die Rekombination der Signale, die entsprechend von den zwei Ausgangsanschlüssen geliefert werden, gewährleistet.

**16.** Elektronisches System (600, 700) nach einem der Ansprüche 12 oder 15, **dadurch gekennzeichnet, dass** die Ausgangsstufe (607) wenigstens zwei Transistoren (Q'1, Q'2) enthält, deren Gates (711, 723) mit entsprechenden Eingangsanschlüssen (605, 606, 709, 721) der Ausgangsstufe verbunden sind, wobei die Sources mit entsprechenden Versorgungsanschlüssen des Systems verbunden sind und die Drains mit dem Ausgangsanschluss (602, 714) der Ausgangsstufe verbunden sind.

**17.** Elektronisches System nach Anspruch 3, wobei die Teilerschaltung einerseits mit einem Eingangsanschluss $V_{in}$ und andererseits mit einem Anschluss, der auf einem ersten Referenzpotential ($V_{SS}$, $V_{DD}$) gehalten wird, verbunden ist, wobei die Schaltung einen Ausgangsanschluss ($V_{out}$) enthält, **dadurch gekennzeichnet, dass** es einen Transistor (Q1) des SOI-Typs enthält, der ein Gate (308), das insbesondere mit dem Ausgangsanschluss ($V_{out}$) der Schaltung verbunden ist, eine Source (305) und einen Drain (306), die miteinander und mit dem auf dem ersten Referenzpotential ($V_{SS}$, $V_{DD}$) gehaltenen Anschluss verbunden sind, umfasst, und dass es außerdem Vorspannungsmittel (705) für den Transistor enthält, die einerseits mit dem Gate des Transistors und andererseits mit einem auf einem zweiten Referenzpotential ($V_{SS}$, $V_{DD}$) gehaltenen Anschluss verbunden sind.

**18.** Elektronisches System nach Anspruch 17, **dadurch gekennzeichnet, dass** der Transistor (Q1) vom Typ N ist, dass der auf einem ersten Referenzpotential gehaltene Anschluss ein Versorgungsanschluss auf niedrigem Potential einer Versorgungsspannung ($V_{SS}$) ist, dass der auf einem zweiten Referenzpotential gehaltene Anschluss ein Versorgungsanschluss auf hohem Potential einer Versorgungsspannung ($V_{DD}$) ist und dass die Vorspannungsmittel (705) des Transistors insbesondere eine Stromquelle und einen Transistor des Typs P enthalten, dessen Source und dessen Gate miteinander und mit der Stromquelle verbunden sind.

**19.** Elektronisches System nach Anspruch 17, **dadurch gekennzeichnet, dass** der Transistor (Q2) vom Typ P ist, dass der auf einem ersten Referenzpotential gehaltene Anschluss ein Versorgungsanschluss auf hohem Potential einer Versorgungsspannung ($V_{DD}$) ist, dass der auf einem zweiten Referenzpotential gehaltene Anschluss ein Versorgungsanschluss auf niedrigem Potential einer Versorgungsspannung ($V_{SS}$) ist und dass die Vorspannungsmittel (705) des Transistors insbesondere eine Stromquelle und einen Transistor des Typs N enthalten, dessen Drain und dessen Gate miteinander und mit der Stromquelle verbunden sind.

EP 1 318 599 B1

## Fig. 1
(ART ANTERIEUR)

$V_1$

$V_{DD}$

102

104

103

101

105

$V_{SS}$

$V_2$

100

## Fig. 2
(ART ANTERIEUR)

$H2 = \dfrac{V_2}{V_1}$

201

202

203

$V_T$

$2V_T$

$V_{C1}$

$(V_{DD} - V_{SS})$

Fig.3

Fig.4a

Fig.4b

Fig. 6

Fig. 7

$V_{out}$ 714

$V_{in}$ 701

$V_{DD}$

$V_{SS}$

712 $Q'_1$ 711 713 709 708 707 710 706
725 $Q'_2$ 723 724 721 720 719 722
$C_1$ 702 703 $C_2$ 716 715 718
$Q_1$ 704 $Q_2$ 717
705 705
B1 B2
700

Fig. 5

Fig. 8

EP 1 318 599 B1

**EP 1 318 599 B1**

**RÉFÉRENCES CITÉES DANS LA DESCRIPTION**

**Documents brevets cités dans la description**

- US 6172378 B
- CH 597636
- EP 0239820 A
- EP 0679968 A